# EUROPEAN PATENT SPECIFICATION

(11) **EP 2 679 384 B1**
(45) Date of publication and mention of the grant of the patent: **13.05.2015**
(21) Application number: 12763155.4
(22) Date of filing: 08.03.2012
(51) Int. Cl.: B32B 15/08, H05K 1/03

(54) **METALLIC FOIL COMPOSITE, FLEXIBLE PRINTED CIRCUIT BOARD USING SAME, MOLDED BODY, AND MANUFACTURING METHOD FOR MOLDED BODY**
METALLFOLIENVERBUNDSTOFF, FLEXIBLE BESTÜCKTE LEITERPLATTE DAMIT, FORMKÖRPER UND HERSTELLUNGSVERFAHREN FÜR DEN FORMKÖRPER
COMPOSITE DE FEUILLE MÉTALLIQUE, CARTE DE CIRCUIT IMPRIMÉ SOUPLE UTILISANT LEDIT COMPOSITE, CORPS MOULÉ ET PROCÉDÉ DE FABRICATION DE CORPS MOULÉ

(30) Priority: 31.03.2011 JP 2011080476
(43) Date of publication of application: 01.01.2014
(73) Proprietor: JX Nippon Mining & Metals Corporation, Tokyo 100-8164 (JP)
(72) Inventor: KAMMURI, Kazuki, Ibaraki 317-0056 (JP)
(74) Representative: Prüfer & Partner GbR European Patent Attorneys
(86) International application number: PCT/JP2012/055933
(87) International publication number: WO 2012/132814

(56) References cited:
- WO-A1-2011/004664
- JP-A- 2006 240 073
- JP-A- 2010 194 759

## Description

### Field of the Invention

The present invention relates to a metal foil composite suitable for an electromagnetic shielding material, a copper laminate for FPC and a substrate to be heat dissipated, a flexible printed circuit using the same, a formed product and a method of producing the same.

### Description of the Related Art

A metal foil composite comprising a metal foil such as a copper or an aluminum foil and a resin film laminated thereon is used as an electromagnetic shielding material (see Patent Literature 1). As to the copper foil which is one of the metal foils, the resin film is laminated for reinforcing the copper foil. A method of laminating the resin film on the copper foil includes a method of laminating the resin film on the copper foil with an adhesive agent, and a method of vapor-depositing copper on the surface of the resin film. In order to ensure the electromagnetic shielding properties, the thickness of the copper foil should be several µm or more. Thus, a method of laminating the resin film on the copper foil is inexpensive.

In addition, the copper foil has excellent electromagnetic shielding properties. So, a material to be shielded is covered with the copper foil so that all surfaces of the material can be shielded. In contrast, if the material to be shielded is covered with a copper braid or the like, the material to be shielded is exposed at mesh parts of the copper braid, resulting in poor electromagnetic shielding properties.

Other than the electromagnetic shielding material, a composite of a copper foil and a resin film (PET, PI (polyimide), an LCP (liquid crystal polymer) and the like) is used for an FPC (flexible printed circuit). In particular, PI is mainly used for the FPC.

The FPC may be flexed or bent. The FPC having excellent flexibility has been developed and is used for a mobile phone (see Patent Literature 2). In general, the flex or bend in flexed parts of the FPC is a bending deformation in one direction, which is simple as compared with the deformation when the electromagnetic shielding material wound around electric wires is flexed. The formability of composite for the FPC is less required.

In contrast, the present applicant reports that the copper foil composite has improved elongation and formability, when there exists any relationship between thicknesses of the copper foil and the resin film and a stress of the copper foil under tensile strain of 4% (see Patent Literature 3).

### [Prior Art Literature]

### [Patent Literature]

[Patent Literature 1] Japanese Unexamined Patent Publication No. Hei7-290449
[Patent Literature 2] Japanese Patent No. 3009383
[Patent Literature 3] International Publication WO 2011/004664

### [Summary of the Invention]

### [Problems to be solved by the Invention]

In recent years, a wide variety of mobile devices including a smartphone gets high functionality. Space-saving parts are needed for mounting on these devices. So, the FPC is folded into small pieces and incorporated into the devices, and the copper foil composite is required to have severe folding properties.

However, the metal foil composite having excellent bending properties is not yet well developed. For example, the technology described in Patent Literature 3 evaluates the formability of the copper foil composite by W bend test. There is no description about the configuration of the copper foil composite showing a good result in 180 degree intimate bend test for evaluating the severe bending properties. In particular, when the copper foil composite is mounted on the device, 180 degree intimate bending may be conducted several times. Thus, the severe bending properties are needed.

When the metal foil composite is used for a heat sink or the like, there is needed press formability to form the heat sink.

Accordingly, an object of the present invention is to provide a metal foil composite having enhanced bending properties, a flexible printed circuit using the same, a formed product and a method of producing the same.

### [Means for Solving the Problems]

The present inventors found that the bending properties can be enhanced by specifying a relationship among elastic modulus of a metal foil, resin and a adhesion layer inserted therebetween of a metal foil composite. Thus, the present invention is attained.

That is, the present invention provides a metal foil composite comprising a resin layer and a metal foil laminated on one or both surfaces of the resin layer via a adhesion layer, wherein elastic modulus of a total layer including the adhesion layer and the resin layer is 80% to 100% of the elastic modulus of the resin layer.

Preferably, 1 <= 33f₁/(F x T) is satisfied when f₁ (N/mm) is 180° peeling strength between the metal foil and the resin layer, F(MPa) is strength of the metal foil composite under tensile strain of 30%, and T (mm) is a thickness of the metal foil composite.

Preferably, (f₃ x t₃)/(f₂ x t₂) => 1 is satisfied, when t₂ (mm) is a thickness of the metal foil, f₂ (MPa) is a stress of the metal foil under tensile strain of 4%, t₃ (mm) is a total thickness of the total layer, and f₃ (MPa) is a stress of the total layer under tensile strain of 4%.

Preferably, fracture strain L of the metal foil composite, fracture strain I₁ of the resin layer alone and fracture strain I₂ of the metal foil satisfy L => I₁ and L > I₂.

Also, the present invention provides a flexible printed circuit, using said metal foil composite, wherein the metal foil is a copper foil.

Also, the present invention provides a copper foil, used for said metal foil composite.

Also, the present invention provides a formed product, provided by working said metal foil composite.

Also, the present invention provides a method of producing a formed product, comprising working said metal foil composite

According to the present invention, there is provided a metal foil composite having enhanced bending properties.

### Brief Description of Drawings

Fig. 1 is a view showing a configuration of a metal foil composite according to an embodiment of the present invention.
Fig. 2 is a graph showing a relationship between f₁ and (F x T) obtained by experiments; and
Fig. 3 shows a schematic configuration of a cup test device for evaluating the formability.

### [Detailed Description of the Invention]

The metal foil composite of the present invention comprises a metal foil and a resin layer via a adhesion layer laminated thereon.

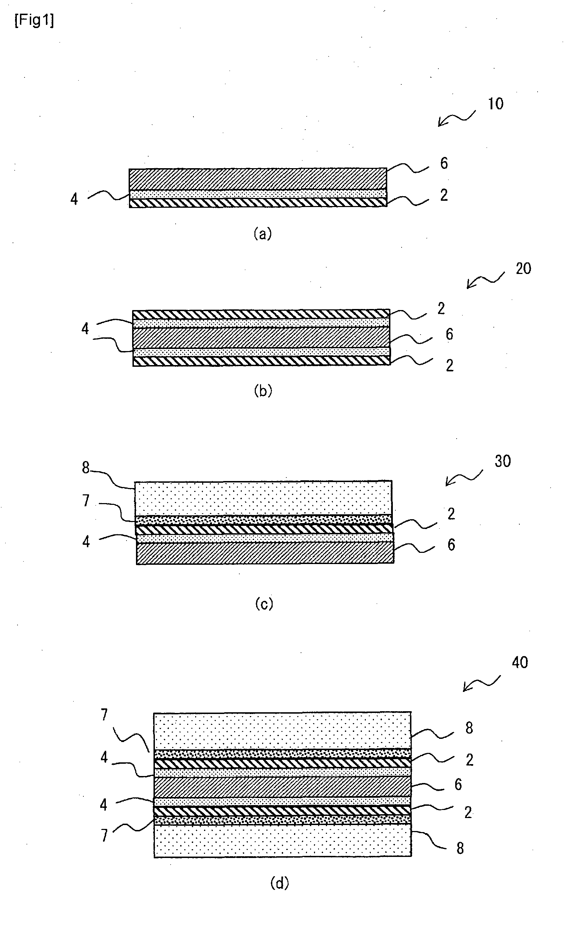

As shown in Fig. 1(a), a metal foil composite 10 according to a first embodiment of the present invention is obtained by laminating a resin layer 6 on one surface of a metal foil 2 via a adhesion layer 4.

As shown in Fig. 1(b), a metal foil composite 20 according to a second embodiment of the present invention is obtained by laminating metal foils 2 on both surfaces of a resin layer 6 disposed at a center in a thickness direction via adhesion layers 4.

As shown in Fig. 1(c), a flexible board 30 is obtained by forming a circuit on a surface of a copper foil 2 of a copper foil composite 10 where a copper foil is used as a metal foil, and laminating a coverlay film 8 on the surface of the circuit via a second adhesion layer 8.

As shown in Fig. 1(d), a flexible board 40 is obtained by forming circuits on surfaces of copper foils 2 of a copper foil composite 20 where a copper foil is used as a metal foil, and laminating coverlay films 8 on the surfaces of the circuits via second adhesion layers 8.

In the metal foil composite, the entire metal foil 2 is high in strength, so that it tends to be difficult to provide a predetermined relationship between the thicknesses of the copper foil and the resin film and a stress of the copper foil in order to improve elongation of the copper foil (metal foil) composite, as described in Patent Literature 3 mentioned above.

In view of the above, the present inventors have focused on elastic modulus of the adhesion layer 4 interposed between the metal foil 2 and the resin layer 6, and have succeeded that the elongation of the metal foil composite is improved by approximating the elastic modulus of the adhesion layer to that of the resin layer, whereby necking of the metal foil is prevented.

The metal foil composite can be used for the FPC and a substrate to be heat dissipated as well as the electromagnetic shielding material. The substrate to be heat dissipated is used so that no circuit is disposed on the FPC of the metal foil, and the metal foil is intimately contacted with the body to be heat dissipated. In the case of the FPC, a copper foil is generally used as the metal foil.

### <Metal foil>

The metal foil is preferably a copper foil, an aluminum foil containing 99 mass% of Al, a nickel foil containing 99 mass% of Ni, a stainless steel foil, a mild steel foil, a Fe-Ni alloy or a nickel silver foil.

Specifically, as the aluminum foil, Al: 99.00 mass% or more of aluminum is soft and thus preferable, of which is represented by alloy numbers of 1085, 1080, 1070, 1050, 1100, 1200, 1N00 and IN30 according to JIS H4000.

Specifically, as the nickel foil, Ni: 99.0 mass% or more of Ni is soft and thus preferable, of which is represented by alloy numbers of NW2200 and NW2201 according to JIS H4551.

The stainless steel is preferably selected from SUS301, SUS304, SUS316, SUS430, SUS631 (all of which are according to JIS standard), each of which can have a thin sheet thickness.

The mild steel foil preferably contains mild steel including 0.15 mass% or less of carbon, and is preferably made of a steel plate according to JIS G3141.

The Fe-Ni alloy foil contains 35 to 85 mass% or more of Ni, the balance being Fe and incidental impurities, and preferably made of Fe-Ni alloy according to JIS C2531.

The nickel silver foil is preferably a foil of alloy numbers of C7351, C7521 and C7541 according to JIS H 3110.

### <Copper foil>

The copper foil is preferably made of oxygen-free copper according to JIS-H3500 (C1011), or tough-pitch copper according to JIS-H3250 (C1100).

Also, the copper foil may contain at least one selected from the group consisting of Sn, Mn, Cr, Zn, Zr, Mg, Ni, Si and Ag at a total concentration of 30 to 500 mass ppm.

When the copper foil contains the above-described element(s), a (100) plane grows and the bending properties are easily improved under the same manufacturing conditions as compared with pure copper. If the content of the above-mentioned element(s) is less than 50 mass ppm, the (100) plane does not grow. If the content exceeds 500 mass ppm, a shear band is formed upon rolling, the (100) plane does not grow, the bending properties are decreased and recrystallized grains may become nonuniform.

### <Thickness of metal foil and tensile fracture strain>

The thickness t₂ of the metal foil is preferably 0.004 to 0.05 mm (4 to 50 µm). When the t₂ is less than 0.004 mm (4 µm), the ductility of the metal foil is significantly decreased, and the formability of the metal foil composite may not be improved.

It is preferred that the tensile fracture strain of the metal foil be 4% or more. When the t₂ exceeds 0.05 mm (50 µm), the properties belonging to the metal foil itself significantly appear on the metal foil composite, and the formability of the metal foil composite may not be improved.

The thickness t₂ of the copper foil is preferably 4 to 35 µm, more preferably 6 to 12 µm. When the t₂ of the copper foil is less than 4 µm, it is difficult to produce. When the t₂ exceeds 35 µm, the stiffness of the copper foil becomes too high, the elongation of a laminate made of the resin and the foil is greater than that of the resin layer, the elongation of the copper foil composite is decreased and the bending properties may be decreased. From the standpoint of the adhesion of the resin layer, heat resistance and the corrosion resistance, the copper foil may be surface-treated such as roughening treatment. The surface treatments, for example, described in Japanese Unexamined Patent Publication No. 2002-217507, Japanese Unexamined Patent Publication No. 2005-15861, Japanese Unexamined Patent Publication No. 2005-4826, Japanese Examined Patent Publication No. Hei 7-32307 and the like can be used.

An average grain size of the copper foil is preferably 50 µm or more. A strength of the copper foil under tensile strain of 4% is preferably less than 130 MPa, since ductility of the copper foil composite is improved even if the resin layer is thin (12 µm or less).

### <Resin layer>

As the resin layer, a resin film that can be adhered to the metal foil via an adhesive layer described layer is used. Examples of the resin film include a PET (polyethylene terephthalate) film, a PI (polyimide) film, an LCP (liquid crystal polymer) film and a PEN (polyethylene naphthalate) film. In particular, the PI film is preferable in that the adhesion is high and the resin layer alone is well elongated.

The thickness of the resin layer can be about 10 to 50 µm.

The elongation of the resin layer is preferably high, but about 30 to 70% is desirable in order to provide other properties such as dimensional stability and heat resistance at the same time.

The elastic modulus of the resin layer can be 2 to 8 GPa. If the elastic modulus of the resin layer is less than 2 GPa, it does not produce an effect to improve the elongation of the metal foil once the metal foil composite is made. If the elastic modulus exceeds 8 GPa, the stiffness becomes too high to decrease the flexibility of the resin layer and lower the formability.

### <Adhesion layer>

The adhesion layer is interposed between the resin film and the metal foil to adhere them. The adhesion layer is for transmitting the deformation behavior of the resin layer to the metal foil and deforming the metal foil in the same way as the resin layer, whereby the metal foil is hardly constricted, and the ductility is increased. When the strength of the adhesion layer is low, the deformation is relaxed by the adhesion layer, so the behavior of the resin cannot be transmitted to the metal foil.

In view of the above, the elastic modulus of the adhesion layer is preferably 0.2 GPa to 5 GPa. If the elastic modulus of the adhesion layer exceeds 5GPa, the flexibility is lowered and the adhesion properties are decreased, whereby an adhesive interface is easily peeled. If the elastic modulus of the adhesion layer is less than 0.2 GPa, elastic modulus E of the total layer including the resin layer and the adhesion layer is difficult to be 80 to 100% of the elastic modulus Ea of the resin layer, even if the thickness of the adhesion layer is reduced, resulting in a decrease in the ductility. If the elastic modulus of the adhesion layer is less than 0.2 GPa, the adhesion layer is thin and the adhesion properties between the metal foil and the resin layer are decreased to be easily peeled.

In the adhesion layer, a wide variety of known resin adhesive agents can be used, and the resin having the same components as the resin layer can be used. For example, the resin layer can be PI, and the adhesion layer can be thermoplastic PI.

The thickness t₅ of the adhesion layer is preferably 0.1 to 20 µm, more preferably 0.5 to 5 µm. It is desirable to thin the thickness t₅ of the adhesion layer, since the improvement of the elongation of the metal foil by the elongation of the resin layer in the metal foil composite is not inhibited when the thickness t₅ becomes thin.

Upon the measurement of the elastic modulus of the adhesion layer, when the adhesive layer alone can be available in addition to the metal foil composite, the elastic modulus of the adhesion layer alone is measured.

On the other hand, when the adhesion layer alone cannot be available, the resin layer and the metal foil are peeled from the metal foil composite using a solvent to provide the adhesion layer alone and to measure the elastic modulus thereof.

When the resin layer cannot be peeled from the metal foil composite and the adhesion layer alone cannot be available, half of the resin layer is mechanically grounded to measure elastic modulus of the total layer including the adhesion layer and the resin layer. While the resin layer is further grounded, the elastic modulus is measured until it is uniform. The value at the point is taken as the elastic modulus.

When the adhesion layer is dissolved in a solvent or an alkali solution, elastic modulus and the thickness of the total layer including the adhesion layer and the resin layer are measured after the metal foil is removed with an acid. Further, the adhesion layer is removed with a solvent or an alkali to measure the elastic modulus and the thickness of the resin layer to calculate the value of the adhesion layer by a mixturing rule.

In the metal foil composite of the present invention, elastic modulus E of the total layer including the adhesion layer and the resin layer needs to be 80 % or more to 100% or less of the elastic modulus Ea of the resin layer. The adhesion layer is for transmitting the deformation behavior of the resin layer to the metal foil and deforming the metal foil in the same way as the resin layer, whereby the metal foil is hardly constricted and the ductility is increased. When elastic modulus of the total layer including the adhesion layer and the resin layer is less than 80% of the elastic modulus of the resin layer, the adhesion layer relaxes the deformation of the resin layer, the deformation behavior of the resin layer is difficult to be transmitted to the metal foil and the metal foil is constricted, so the ductility is decreased. When elastic modulus of the total layer exceeds 100%, the ductility of the adhesion layer itself is decreased to decrease the ductility of the laminate.

The elastic modulus E of the total layer can be measured such that the adhesion layer and the resin layer are considered as one layer. Alternatively, after the elastic modulus of each layer is measured individually, the mixturing rule may be applied to calculate the elastic modulus E of the total layer.

Herein, when the mixturing rule is used, the elastic modulus E of the total layer is represented by E = (Ea x ta + Eb x tb)/(ta + tb), where Ea is elastic modulus of the resin layer, ta is a thickness of the resin layer, Eb is elastic modulus of the adhesion layer and tb is a thickness of the adhesion layer.

It is preferably 1 <= 33f₁/(F x T) is satisfied, where f₁ (N/mm) is 180° peeling strength between the metal foil and the resin layer, F(MPa) is strength of the metal foil composite under tensile strain of 30%, and T (mm) is a thickness of the metal foil composite.

Since the metal foil is thin, necking is easily occurred in a thickness direction. When the necking is produced, the metal foil is broken and the ductility is therefore decreased. On the other hand, the resin layer has a property that the necking is difficult to be produced when tension is applied (i.e., the resin layer has a wide area with uniform strain). Thus, in the composite comprising the metal foil and the resin layer, when the deformation behavior of the resin layer is transmitted to the metal foil, and the metal foil is deformed together with the resin layer, the necking of the metal foil is hardly occurred, and the ductility is increased. When the adhesion strength between the metal foil and the resin layer is low, the deformation behavior of the resin layer cannot be transmitted to the metal foil, so the ductility is not improved (the metal foil is peeled and cracked).

Then, high adhesion strength is needed. A direct indicator of the adhesion strength is shear bond strength. If the adhesion strength is increased such that a level of the shear bond strength is similar to that of the metal foil composite, the area other than the bonding surface is broken to make a measurement difficult.

In view of the above, the value f₁ of 180° peeling strength is used. Although the absolute values of the shear bond strength and the 180° peeling strength are totally different, there is a correlation between the formability, tensile elongation and the 180° peeling strength. So, the 180° peeling strength is deemed as an indicator of the adhesion strength.

In fact, it is considered that "the strength at the time of the material is broken" is equal to "the shear bond strength." As an example, it is considered that when 30% or more of the tensile strain is required, "30% of a flow stress <= shear bond strength." When 50% or more of the tensile strain is required, "50% of a flow stress <= shear bond strength." According to the experiments by the present inventors, the formability was excellent when the tensile strain exceeded 30% or more. So, the strength obtained when the tensile strain is 30% is defined as the strength F of the metal foil composite, as described later.

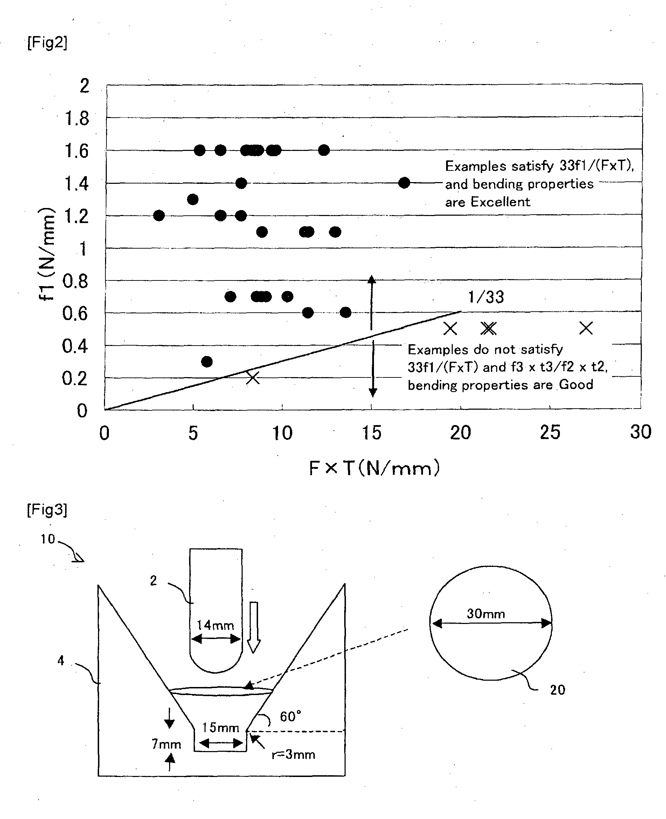

Fig. 2 is a graph showing a relationship between f₁ and (F x T) obtained by experiments, and plots the value of f₁ and (F x T) in each Example and Comparative Example. (F x T) is the strength of the metal foil composite under tensile strain of 30% when a copper foil is used as the metal foil, and if this is regarded as the minimum shear bond strength required for increasing the formability, f₁ and (F x T) are correlated at the slope of 1as long as the absolute values of these are same.

However, in Fig. 2, the values of f₁ and (F x T) in all data are not correlated similarly. In each Comparative Example with poor formability, the coefficient of correlation f₁ to (F x T) (in other words, the slope of f₁ to (F x T) from the origin point in Fig. 2) is gentle, and the 180° peeling strength is correspondingly poor. On the other hand, the slope of each Example is greater than that of each Comparative Example. The slope of Example 18 (just broken under the strain of 30%) is gentlest and is 1/33. Thus, this value is regarded as the correlation function between the minimum shear bond strength and the 180° peeling strength for increasing the formability. In other words, it is considered that the shear bond strength is 33 times greater than the 180° peeling strength.

In Comparative Example 3, the slope in Fig. 1 exceeds 1/33. However, equation 1:(f₃ x t₃)/(f₂ x t₂) described later is less than 1, which results in the poor formability.

The 180° peeling strength is represented by force per unit width (N/mm).

When the metal foil composite has a three-layer structure including a plurality of bonding surfaces, the lowest value of the 180° peeling strength out of the bonding surfaces is used. This is because the weakest bonding surface is peeled. In addition, when the copper foil is used as the metal foil, the copper foil generally has an S(Shine) surface and an M(Matte) surface. The S surface has poor adhesion properties. So, the S surface of the copper foil is less adhered to the resin. Accordingly, the 180° peeling strength on the S surface of the copper foil is often used.

In order to increase the adhesion strength between the metal foil and the resin layer, there are a cleaning treatment of the surface of the metal foil, a roughening treatment including etching, mechanical polishing and plating, a chromate treatment, and a plating treatment with a metal such as Cr that is excellent in the adhesiveness.

In particular, in order to increase the adhesion strength between the copper foil and the resin layer, a Cr oxide layer is formed on the surface of the copper foil (on the surface of the resin layer side) by a chromate treatment and so on, the surface of the copper foil is roughened, or the Cr oxide layer is disposed after the surface of the copper foil is Ni coated.

The thickness of the Cr oxide layer may be 5 to 100 µg/dm² based on the weight of Cr. The thickness is calculated from the Cr content by wet analysis. The presence of the Cr oxide layer can be determined by X-ray photoelectron spectroscopy (XPS) for detecting Cr. (The peak of Cr is shifted by oxidation.)

The Ni coating amount may be 90 to 5000 (µg/dm². If the Ni coating amount exceeds 5000 µg/dm² (which corresponds to the Ni thickness of 56 nm), the ductility of the copper foil (and the copper foil composite) may be decreased.

Furthermore, the adhesion strength can be increased by changing the pressure and the temperature conditions when the copper foil and the resin layer are laminated and combined. Insofar as the resin is not damaged, both of the pressure and the temperature upon lamination may be increased.

When the copper foil is used as the metal foil, a plating layer may be formed at a thickness of about 1 µm selected one or more from the group consisting of Sn, Ni, Au, Ag, Co and Cu on a surface of the copper foil opposite to the surface on which the resin layer is formed, in order to improve corrosion resistance (salinity tolerance), to decrease contact resistance or to conduct between the copper foil layers.

### <33f₁/(F x T)>

Then, the meaning of defining (33f₁/(F x T)(hereinafter referred to as "equation 1") will be described. As described above, the shear bond strength which directly shows the minimum adhesion strength between the metal foil(in the example of Fig.2, copper foil is used) and the resin layer required for increasing the formability is about 33 times greater than the 180° peeling strength f₁ In other words, 33f₁ represents the minimum adhesion strength required for improving the formability of the metal foil and the resin layer. On the other hand, (F x T) is the strength of the metal foil composite, and the equation 1 represents a ratio of the adhesion strength between the metal foil and the resin layer to tensile force of the metal foil composite. When the metal foil composite is pulled, a shear stress is induced by the metal foil to be deformed locally and the resin to be subjected to uniform tensile strain at an interface between the metal foil and the resin layer. Accordingly, when the adhesion strength is lower than the shear stress, the metal foil and the resin layer are peeled. As a result, the deformation behavior of the resin layer cannot be transmitted to the metal foil, and the ductility of the metal foil is not improved.

In other words, when the ratio in the equation 1 is less than 1, the adhesion strength is lower than the force applied to the metal foil composite, and the metal foil and the resin tend to be easily peeled. Then, the metal foil may be broken by processing such as press forming.

When the ratio in the equation 1 is 1 or more, the metal foil and the resin layer are not peeled, and the deformation behavior of the resin layer can be transmitted to the metal foil, thereby improving the ductility of the metal foil. The higher ratio in the equation 1 is preferred. However, it is generally difficult to provide the value of 15 or more. The upper limit in the equation 1 may be 15.

In addition, it is considered that the higher formability is, the higher the value of 33f₁/(F x T) is. However, the tensile strain I of the resin layer is not proportional to 33f₁/(F x T). This is because the effects of the magnitude of (f₃ x t₃)/(f₂ x t₂) and the ductility of the metal foil or the resin layer alone. However, the combination of the metal foil and the resin layer which satisfying the equations: 33f₁/(F x T)=>1 and (f₃ x t₃)/(f₂ x t₂)=> 1 can provide the composite having the required formability.

Here, the reason for using the strength obtained when the tensile strain is 30% as the strength F of the metal foil composite is that the formability was excellent when the tensile strain exceeded 30% or more, as described above. Another reason is as follows: When the metal foil composite was subjected to a tensile test, a great difference was produced in the flow stress due to the strain until the tensile strain reached 30%. However, no great difference was produced in the flow stress due to the strain after the tensile strain reached 30% (although the metal foil composite was somewhat work hardened, the slope of the curve became gentle).

When the tensile strain of the metal foil composite is less than 30%, the tensile strength of the metal foil composite is defined as F.

It is preferable that {(f₃ x t₃)/(f₂ x t₂) => 1 is satisfied, where t₂ (mm) is a thickness of the metal foil, f₂ is a stress of the metal foil under tensile strain of 4%, t₃ (mm) is a total thickness of the resin layer and the adhesion layer, and f₃ (MPa) is a stress of the total thickness of the resin layer and the adhesion layer under tensile strain of 4%.

The combination of the metal foil composite comprising the metal foil and the resin layer laminated thereon described above includes a two-layer structure such as the metal foil/(the total layer including the resin layer and the adhesion layer) or a three-layer structure such as (the total layer including the resin and the adhesion layer)/the metal foil/(the total layer including the resin layer and the adhesion layer) or the metal foil/(the total layer including the resin layer and the adhesion layer)/the metal foil. In the case that the total layers of the resin layer and the adhesion layer are disposed on both sides of the copper foil ((the total layer including the resin layer and the adhesion layer)/the metal foil/(the total layer including the resin layer and the adhesion layer)), the total value of (f₃ x t₃) is obtained by adding each value of (f₃ x t₃) calculated about each total layer on both sides of the metal foil. In the case that the metal foils are disposed on both sides of the resin layer ((the metal foil/(the total layer including the resin layer and the adhesion layer)/the metal foil), the total value of (f₂ x t₂) is obtained by adding each value of (f₂ x t₂) calculated about the two metal foils.

When the thickness t₄ of the resin layer and the stress f₄ at 4%, and the thickness t₅ of the adhesiolayer and the stress f₅ at 4% are known respectively, the mixturing rule f₃ x t₃ = (f₄ x t₄) + (f₅ x t₅) may used.

### <(f₃ x t₃)/(f₂ x t₂)>

Next, the meaning of defining (f₃ x t₃)/(f₂ x t₂) (Equation 2) will be described. Since the metal foil composite comprises the metal foil and the resin layer laminated thereon, which have the same width (size), Equation 2 represents a ratio of force applied to the metal foil to the force applied to the total layer in the metal foil composite. When the ratio is 1 or more, much force is applied to the total layer and the total layer is stronger than the metal foil. As a result, the metal foil does not broken and exhibits good formability.

When Equation 2 < 1, too much force is applied to the metal foil, and the above-mentioned effects do not provided, i.e., the deformation behavior of the total layer is not transmitted to the metal foil, and the metal foil is not deformed together with the resin.

Here, f₂, f₃, f₄ and f₅ may be the stress at the same strain amount after the plastic deformation is induced. In consideration of the tensile fracture strain of the metal foil and the strain at the time of starting the plastic deformation of the resin layer (for example, PET film) and the adhesion layer, the stress of f₂, f₃, f₄ and f₅ are set to tensile strain of 4%. The values f₂, f₃, f₄ and f₅ (and f₁) are all obtained in a machine direction (MD).

The f₂ can be measured by tensile test of the metal foil remained after the removal of the resin layer from the metal foil composite by use of a solvent. T and t₂, t₃, t₄ and t₅ can be measured by observing sections of the metal foil composite with a wide variety of microscopes including an optical microscopy.

In addition, if the values of F and f in the metal foil and the resin layer are known before the metal foil composite is produced and if no heat treatment that the properties of the metal foil and the resin layer are greatly changed is conducted upon the production of the metal foil composite, the known values of F and f before the metal foil composite is produced may be used.

It is preferable that fracture strain L of the metal foil composite, fracture strain l₁, of the resin layer alone and fracture strain l₂ of the metal foil satisfy L > l₁ and L > l₂.

The ratio l/L of tensile fracture strain l of the copper foil composite and tensile fracture strain L of the resin layer alone is preferably 0.7 to 1.

In general, the tensile fracture strain of the resin layer is significantly higher than that of the metal foil composite. Similarly, the tensile fracture strain of the resin layer alone is significantly higher than that of the metal foil composite. On the other hand, according to the present invention, the deformation behavior of the resin layer is transmitted to the metal foil, so that the ductility of the metal foil is improved, as described above. The tensile fracture strain of the metal foil composite can be correspondingly enhanced over 100% of the tensile fracture strain of the resin layer alone.

The tensile fracture strain of the metal foil composite is the tensile fracture strain obtained by the tensile test. And, when both the resin layer and the metal foil are broken at the same time, the value of this point is defined as the tensile fracture strain. When the metal foil is broken first, the value when the metal foil is fractured is defined as the tensile fracture strain. The tensile fracture strain L of the resin layer alone is obtained as follows: When the resin layers are disposed on both surfaces of the copper foil, the tensile test is conducted on each resin layer to measure the tensile fracture strain. The greater tensile fracture strain is defined as L. When the resin layers are disposed on both surfaces of the metal foil, each of two resin layers obtained by removing the metal foil is thus measured.

### [Example]

### <Production of metal foil composite>

### <Production of aluminum (Al) foil composite>

An Al foil was obtained at a thickness of 25 µm by cold rolling a commercially available pure aluminum plate having a thickness of 0.1 mm. After the raw foil was degreased and cleaned with 5% NaOH solution, each adhesive agent shown in Table 1 was coated thereon and each resin layer film was laminated on one surface of the Al foil to produce an Al foil composite.

In the following Examples, the resin layer was laminated on one surface of the metal foil to produce the composite in a type shown in Fig. 1(a).

### <Production of nickel (Ni) foil composite>

An Ni ingot with a purity of 99.90 mass% or more was casted, and hot rolling, cold rolling and annealing were repeated to produce an Ni foil (thickness of 17 µm) according to JIS H4551 NW2200Ni. The produced Ni foil was annealed at 700°C for 30 minutes, acid pickled in sulfuric acid for improving the adhesion, and alkali cleaned. Then, Ni sulfamate (current density of 10 A/dm2, plating thickness of 1 µm) was plated thereon. Each adhesive agent shown in Table 1 was coated on one surface of the Ni foil and each resin layer film was laminated on the Ni foil to produce a Ni foil composite.

### <Production of stainless steel foil composite>

Each of commercially available SUS301, SUS304, SUS316, SUS430 and SUS631 stainless steel plate was annealed, soften and cold-rolled to a thickness of 25 µm. Then, the stainless steel was roughened by #400 buffing to a thickness of 18 µm, and was surface-cleaned by ultrasonic waves. Then, the foil was annealed at 1000°C for 5 seconds under argon atmosphere. Each adhesive agent shown in Table 1 was coated on one surface of the stainless steel foil and each resin layer film was laminated on the stainless steel foil to produce a stainless steel foil composite.

### <Production of mild steel foil composite>

A commercially available JIS G3141 SPCCA mild steel plate was cold-rolled by repeating cold-rolling and annealing to a thickness of 25 µm. Then, the mild steel was roughened by #400 buffing to a thickness of 18 µm, and was surface-cleaned by ultrasonic waves. Then, the foil was annealed at 1000°C for 5 seconds under argon atmosphere. Each adhesive agent shown in Table 1 was coated on one surface of the mild steel foil and each resin layer film was laminated on the mild steel foil to produce a mild steel foil composite.

### <Production of Fe-Ni alloy foil composite>

Fe-Ni alloy was casted by vacuum melting to have each composition of Fe-36 mass% Ni, Fe-50 mass% Ni and Fe-85 mass% Ni. Then, each ingot was cold-rolled by repeating hot-rolling, surface grinding, cold-rolling and annealing to a thickness of 25 µm. Each foil was roughened by #400 buffing to a thickness of 18 µm, and was surface-cleaned by ultrasonic waves. Then, the foil was annealed at 1000°C for 5 seconds under argon atmosphere. Each adhesive agent shown in Table 1 was coated on one surface of the Fe-Ni alloy foil and each resin layer film was laminated on the Fe-Ni alloy foil to produce a Fe-Ni alloy foil composite.

### <Production of nickel silver foil composite>

An ingot was casted so that the component described in JIS H3110 C7451 was obtained, and hot rolling, cold rolling and annealing were repeated to produce a nickel silver foil having a thickness of 25 µm. Then, the foil was recrystallization annealed at 800°C for 10 seconds under argon atmosphere, acid pickled in a sulfuric acid solution, and alkali cleaned. Then, Ni sulfamate (current density of 10 A/dm2, plating thickness of 1 µm) was plated thereon. Then, each adhesive agent shown in Table 1 was coated on one surface of the nickel silver foil and each resin layer film was laminated on the nickel silver foil to produce a nickel silver foil composite.

### <Production of copper foil composite>

To tough-pitch copper (Examples 1 to 40, 51 and 52) and oxygen-free copper (Examples 41 to 50), each element-added ingot shown in Table 1 was hot-rolled, surface grinded to remove oxides, cold-rolling, annealing and acid picking were repeated to a predetermined thin thickness, and finally annealed to provide each copper foil with formability. In order to provide the copper foil with a uniform texture in a width direction, tension upon cold-rolling and rolling reduction conditions of the rolled material in a width direction were constant. In the next annealing, a plurality of heaters were used to control the temperature so that a uniform temperature distribution was attained in the width direction, and the temperature of the copper was measured and controlled.

The oxygen-free copper was according to JIS-H3100 (C1020), and the touch-pitch copper was according to JIS-H3100 (C1100).

Also in each of Comparative Examples 1 to 8, the copper foil was used to provide the above-described tough-pitch copper, and the copper foil composite was produced as in Examples 1 to 52.

A typical surface treatment used in CCL was conducted on the surface of the resultant copper foil. The surface treatment described in Japanese Examined Patent Publication No. Hei7-3237 was used. After the surface treatment, the surface of the copper foil was coated with each adhesive agent shown in Tables 1 and 2, and each resin layer film was laminated on the copper foil to produce the CCL (copper foil composite).

### <Tensile test>

A plurality of strip test specimens each having a width of 12.7 mm were produced from the metal foil composites. Some strip test specimens were immersed in a solvent (TPE3000 manufactured by Toray Engineering Co., Ltd., formic acid) to dissolve the adhesion layer and the PI film and to provide the test specimens each having only the metal foil. In some test specimens, the metal foils were dissolved with ferric chloride and the like to provide the test specimens of the only total layer having the resin layer and the adhesion layer. The total layer including the resin layer and the adhesion layer was immersed into N-methyl-2-pyrrolidone or formic acid to provide the test specimen only including the resin layer.

The tensile test was conducted under the conditions that a gauge length was 100 mm and the tension speed was 10 mm/min. An average value of N10 was employed for strength (stress) and strain(elongation).

### <Elastic modulus>

The elastic modulus Ea of the resin layer and the elastic modulus E of the total layer were calculated from the values obtained in the tensile test, respectively.

### <Evaluation of metal foil composite>

### <180° intimate bending (bending properties)>

According to JIS Z 2248, the metal foil composites were bent intimately at 180°. The bent part at 180° was returned to 0°, and again bent at 180°. After 180° intimate bending were performed five times, the surfaces of the bent metal foils were observed. The intimate bending is to evaluate the bending properties of the metal foil composite.

### <Press formability>

The formability was evaluated using a. cup test device 10 shown in Fig. 3. The cup test device 10 comprised a pedestal 4 and a punch 2. The pedestal 4 had a frustum slope. The frustum was tapered from up to down. The frustum slope was tilted at an angle of 60° from a horizontal surface. The bottom of the frustum was communicated with a circular hole having a diameter of 15 mm and a depth of 7 mm. The punch 2 was a cylinder and had a tip in a semispherical shape with a diameter of 14 mm. The semispherical tip of the punch 2 could be inserted into the circular hole of the frustum.

A connection part of the tapered tip of the frustum and the circular hole at the bottom of the frustum was rounded by a radius (r) = 3mm.

The metal foil composite was punched out to provide the test specimen 20 in a circular plate shape with a diameter of 30 mm, and was disposed on the slope of the frustum of the pedestal 4. The punch 2 was pushed down on the top of the test specimen 20 to insert it into the circular hole of the pedestal 4. Thus, the test specimen 20 was formed in a conical cup shape.

In the case the resin layer was disposed on one surface of the metal foil composite, the metal foil composite was disposed on the pedestal 4 such that the resin layer was faced upward. In the case the resin layers were disposed on both surfaces of the metal foil composite, the metal foil composite was disposed on the pedestal 4 such that the resin layer bonded to the M surface was faced upward. In the case the both surfaces of the metal foil composite was Cu, either surface might be faced upward.

After molding, the crack of the metal foil in the test specimen 20 was visually identified. The formability was evaluated the following scales:

These metal foil composites were evaluated by the following scales:
Excellent: the metal foil was not cracked and had no necking.
Good: the metal foil had small wrinkles (necking) but had no large ones.
Not Good: the metal foil had large necking, but was not cracked.
Bad: the metal foil was cracked.

As to the W bending and the 180° intimate bending, "Excellent" and "Good" results are OK. As to the press formability, which are not essential evaluation, "Excellent" and "good" results are preferable.

The results are shown in Tables 1 to 6. In Tables, "TS" means tensile strength.

**[Table 1]**

| | Metal foil | | | | Resin layer and adhesion layer | | | | | |
|---|---|---|---|---|---|---|---|---|---|---|
| | Composition (Copper foil in Examples 1-52) | t2 (mm) | f2 (MPa) | I₂ (%) | Resin layer | | | Adhesion layer | t3 (mm) | f3 (MPa) |
| | | | | | Type | Ea (Gpa) | I₁ (%) | Type | | |
| Example 1 | Ag:50ppm | 0.009 | 110 | 4 | PI | 5.8 | 54 | PI | 0.013 | 140 |
| Example 2 | Ag:100ppm | 0.012 | 95 | 6 | PI | 5.8 | 54 | PI | 0.013 | 140 |
| Example 3 | Ag:200ppm | 0.012 | 110 | 5 | PI | 5.8 | 60 | PI | 0.027 | 140 |
| Example 4 | Ag:200ppm | 0.012 | 110 | 5 | PI | 5.8 | 54 | PI | 0.017 | 126 |
| Example 5 | Ag:200ppm | 0.012 | 110 | 5 | PI | 5.8 | 54 | PI | 0.022 | 115 |
| Example 6 | Ag:200ppm | 0.012 | 110 | 5 | PI | 5.8 | 54 | PI | 0.027 | 109 |
| Example 7 | Ag:200ppm | 0.012 | 110 | 5 | PI | 5.8 | 54 | PI | 0.037 | 101 |
| Example 8 | Ag:500ppm | 0.012 | 113 | 7 | PI | 3.4 | 80 | PI | 0.027 | 140 |
| Example 9 | Sn:30ppm | 0.012 | 98 | 4 | PI | 3.4 | 80 | PI | 0.027 | 140 |
| Example 10 | Zr:70ppm | 0.012 | 115 | 4 | PI | 3.4 | 80 | PI | 0.027 | 140 |
| Example 11 | Ag:100ppm Zn:50ppm | 0.012 | 95 | 4 | PI | 3.4 | 80 | PI | 0.027 | 140 |
| Example 12 | Ag:100ppm Ni:50ppm | 0.012 | 110 | 4 | PI | 3.4 | 80 | PI | 0.027 | 140 |
| Example 13 | Ag:100ppm Mg:50ppm | 0.012 | 115 | 4 | PI | 3.4 | 80 | PI | 0.027 | 140 |
| Example 14 | Ag:100ppm Cr:50ppm | 0.012 | 124 | 4 | PI | 3.4 | 80 | PI | 0.027 | 140 |
| Example 15 | Ag:100ppm Si:50ppm | 0.012 | 125 | 4 | PI | 3.4 | 80 | PI | 0.027 | 140 |
| Example 16 | - | 0.018 | 143 | 14 | PI | 5.8 | 57 | PI | 0.014 | 136 |
| Example 17 | Ag:200ppm | 0.018 | 110 | 7 | PI | 3.4 | 80 | PI | 0.05 | 101 |
| Example 18 | - | 0.035 | 180 | 23 | PI | 3.4 | 57 | PI | 0.05 | 123 |
| Example 19 | - | 0.033 | 152 | 18 | PI | 3.4 | 57 | PI | 0.05 | 123 |
| Example 20 | - | 0.035 | 180 | 23 | PI | 5.8 | 54 | PI | 0.039 | 142 |
| Example 21 | - | 0.012 | 143 | 12 | PI | 5.8 | 54 | Epoxy+acrylic | 0.023 | 99 |
| Example 22 | - | 0.018 | 145 | 15 | PI | 5.8 | 54 | Epoxy+acrylic | 0.023 | 122 |

**[Table 2]**

| | Metal foil | | | | Resin layer and adhesion layer | | | | | |
|---|---|---|---|---|---|---|---|---|---|---|
| | Composition (Copper foil in Examples 1-52) | t2 (mm) | f2 (MPa) | I₂ (%) | Resin layer | | | Adhesion layer | t3 (mm) | f3 (MPa) |
| | | | | | Type | Ea (Gpa) | I₁ (%) | Type | | |
| Example 23 | - | 0.007 | 149 | 7 | PET | 6 | 40 | Urethane | 0.015 | 118 |
| Example 24 | - | 0.007 | 149 | 7 | PET | 6 | 40 | Urethane | 0.015 | 118 |
| Example 25 | - | 0.007 | 149 | 7 | PET | 6 | 40 | Epoxy+acrylic | 0.015 | 124 |
| Example 26 | - | 0.009 | 110 | 5 | PI | 5.5 | 54 | PI | 0.014 | 136 |
| Example 27 | Ag:200ppm | 0.012 | 110 | 5 | PI | 5.5 | 57 | PI | 0.029 | 136 |
| Example 28 | - | 0.012 | 143 | 12 | PI | 5.5 | 54 | PI | 0.014 | 136 |
| Example 29 | - | 0.018 | 145 | 15 | PI | 5.5 | 54 | PI | 0.014 | 136 |
| Example 30 | Ag:50ppm | 0.018 | 95 | 6 | PI | 5.5 | 57 | PI | 0.029 | 136 |
| Example 31 | Ag:100ppm | 0.018 | 95 | 5 | PI | 5.5 | 54 | PI | 0.014 | 136 |
| Example 32 | Ag:200ppm | 0.012 | 110 | 5 | PI | 5.5 | 54 | PI | 0.014 | 136 |
| Example 33 | Ag:500ppm | 0.018 | 113 | 7 | PI | 5.5 | 54 | PI | 0.014 | 136 |
| Example 34 | - | 0.033 | 152 | 18 | PI | 5.5 | 54 | PI | 0.029 | 136 |
| Example 35 | - | 0.012 | 143 | 12 | PI | 6.3 | 43 | PI | 0.014 | 136 |
| Example 36 | - | 0.035 | 200 | 27 | PI | 6.3 | 43 | PI | 0.045 | 136 |
| Example 37 | - | 0.012 | 143 | 12 | PI | 5.8 | 60 | PJ | 0.027 | 140 |
| Example 38 | Ag:200ppm | 0.012 | 110 | 5 | PI | 5.8 | 60 | PI | 0.014 | 136 |
| Example 39 | Ag:200ppm | 0.012 | 110 | 5 | PI | 5.8 | 60 | PI | 0.029 | 136 |
| Example 40 | - | 0.012 | 143 | 12 | PI | 5.8 | 60 | PI | 0.029 | 136 |
| Comparative Example 1 | - | 0.012 | 143 | 12 | PI | 5.8 | 54 | Epoxy+acrylic | 0.023 | 99 |
| Comparative Example 2 | - | 0.012 | 143 | 12 | PI | 5.8 | 54 | PI | 0.018 | 127 |
| Comparative Example 3 | - | 0.012 | 143 | 12 | PI | 5.8 | 54 | Epoxy+acrylic | 0.023 | 99 |
| Comparative Example 4 | - | 0.012 | 143 | 12 | PI | 5.8 | 54 | PI | 0.018 | 127 |
| Comparative Example 5 | - | 0.012 | 143 | 12 | PI | 5.8 | 54 | Epoxy-I-acrylic | 0.028 | 108 |
| Comparative Example 6 | - | 0.012 | 143 | 12 | PI | 5.8 | 54 | PI | 0.018 | 127 |
| Comparative Example 7 | - | 0.008 | 143 | 12 | PET | 6 | 40 | Urethane | 0.015 | 109 |
| Comparative Example 8 | - | 0.008 | 143 | 12 | PET | 6 | 40 | Urethane | 0.022 | 84 |

**[Table 3]**

| | Metal foil | | | | Resin layer and adhesion layer | | | | | |
|---|---|---|---|---|---|---|---|---|---|---|
| | Composition (Copper foil in Examples 1-52) | t2 (mm) | f2 (MPa) | I₂ (%) | Resin layer | | | Adhesion layer | t3 (mm) | f3 (MPa) |
| | | | | | Type | Ea (Gpa) | I₁ (%) | Type | | |
| Example 41 | - | 0.018 | 147 | 14 | PI | 6.3 | 43 | PI | 0.045 | 136 |
| Example 42 | Ag:50ppm | 0.018 | 114 | 9 | PI | 6.3 | 43 | PI | 0.045 | 136 |
| Example 43 | Ag:100ppm | 0.018 | 98 | 7 | PI | 6.3 | 43 | PI | 0.045 | 136 |
| Example 44 | Ag:200ppm | 0.018 | 95 | 7 | PI | 6.3 | 43 | PI | 0.045 | 136 |
| Example 45 | Sn:50ppm | 0.018 | 102 | 9 | PI | 6.3 | 43 | PI | 0.045 | 136 |
| Example 46 | Sn:100ppm | 0.018 | 115 | 12 | PI | 6.3 | 43 | PI | 0.045 | 136 |
| Example 47 | Ag:100ppm Zn:50ppm | 0.018 | 102 | 12 | PI | 6.3 | 43 | PI | 0.045 | 136 |
| Example 48 | Ag:100ppm Ni:50ppm | 0.018 | 105 | 14 | PI | 6.3 | 43 | PI | 0.045 | 136 |
| Example 49 | Ag:100ppm Mg:50ppm | 0.018 | 112 | 15 | PI | 6.3 | 43 | PI | 0.045 | 136 |
| Example 50 | Ag:100ppm Cr:50ppm | 0.018 | 115 | 16 | PI | 6.3 | 43 | PI | 0.045 | 136 |
| Example 51 | - | 0.018 | 145 | 18 | PI | 5.8 | 60 | Epoxy+acrylic | 0.035 | 128 |
| Example 52 | - | 0.018 | 145 | 18 | PET | 6 | 40 | Urethane | 0.015 | 118 |
| Example 53 | AI | 0.025 | 90 | 6 | PI | 6.3 | 57 | PI | 0.055 | 133 |
| Example 54 | Ni | 0.018 | 290 | 12 | PI | 6.3 | 57 | PI | 0.055 | 133 |
| Example 55 | SUS301 | 0.018 | 260 | 15 | PI | 6.3 | 57 | PI | 0.055 | 133 |
| Example 56 | SUS304 | 0.018 | 264 | 17 | PI | 6.3 | 57 | PI | 0.055 | 133 |
| Example 57 | SUS316 | 0.018 | 275 | 15 | PI | 6.3 | 57 | PI | 0.055 | 133 |
| Example 58 | SUS430 | 0.018 | 265 | 12 | PI | 6.3 | 57 | PI | 0.055 | 133 |
| Example 59 | SUS631 | 0.018 | 360 | 14 | PI | 6.3 | 57 | PI | 0.055 | 133 |
| Example 60 | Mild steel | 0.018 | 250 | 13 | PI | 6.3 | 57 | PI | 0.055 | 133 |
| Example 61 | Fe-36Ni | 0.018 | 330 | 14 | PI | 6.3 | 57 | PI | 0.055 | 133 |
| Example 62 | Fe-50Ni | 0.018 | 360 | 13 | PI | 6.3 | 57 | PI | 0.055 | 133 |
| Example 63 | Fe-85Ni | 0.018 | 330 | 15 | PI | 6.3 | 57 | PI | 0.055 | 133 |
| Example 64 | Nickel silver | 0.026 | 370 | 13 | PI | 6.3 | 57 | PI | 0.055 | 133 |

**[Table 4]**

| | | | Metal foil composite | | | | | | | | | | |
|---|---|---|---|---|---|---|---|---|---|---|---|---|---|
| | E (Gpa) | E/Ea x100 | Structure | T (mm) | f1 (N/mm) | F (MPa) | L (%) | L/I₁ | L/I2 | 33f1 /(FxT) | (f3xt3) / (f2xt2) | Evalutation | |
| | | | | | | | | | | | | Bending properties | Press formability |
| Example 1 | 5.5 | 94.7 | a | 0.022 | 1.30 | 223 | 55 | 1.02 | 13.75 | 8.8 | 1.84 | Excellent | Excellent |
| Example 2 | 5.5 | 94.7 | a | 0.025 | 1.60 | 211 | 58 | 1.07 | 9.67 | 10.0 | 1.60 | Excellent | Excellent |
| Example 3 | 5.5 | 94.9 | a | 0.039 | 1.60 | 240 | 65 | 1.08 | 13.00 | 5.7 | 2.87 | Excellent | Excellent |
| Example 4 | 4.9 | 84.8 | a | 0.029 | 1.60 | 222 | 48 | 0.89 | 9.60 | 8.2 | 1.62 | Excellent | Good |
| Example 5 | 4.7 | 80.4 | a | 0.034 | 1.60 | 232 | 45 | 0.83 | 9.00 | 6.7 | 1.92 | Excellent | Good |
| Example 6 | 3.1 | 90.2 | a | 0.039 | 1.60 | 240 | 59 | 1.09 | 11.80 | 5.7 | 2.23 | Excellent | Excellent |
| Example 7 | 3.0 | 88.1 | a | 0.049 | 1.60 | 250 | 45 | 0.83 | 9.00 | 4.3 | 2.83 | Excellent | Good |
| Example 8 | 3.3 | 96.5 | a | 0.039 | 1.60 | 240 | 107 | 1.34 | 15.29 | 5.7 | 2.79 | Excellent | Excellent |
| Example 9 | 3.3 | 96.5 | a | 0.039 | 1.60 | 215 | 87 | 1.09 | 21.75 | 6.3 | 3.22 | Excellent | Excellent |
| Example 10 | 3.3 | 96.5 | a | 0.039 | 1.60 | 240 | 82 | 1.03 | 20.50 | 5.6 | 2.74 | Excellent | Excellent |
| Example 11 | 3.3 | 96.5 | a | 0.039 | 1.60 | 210 | 91 | 1.14 | 22.75 | 6.4 | 3.32 | Excellent | Excellent |
| Example 12 | 3.3 | 96.5 | a | 0.039 | 1.60 | 220 | 90 | 1.13 | 22.50 | 6.2 | 2.87 | Excellent | Excellent |
| Example 13 | 3.3 | 96.5 | a | 0.039 | 1.60 | 242 | 87 | 1.09 | 21.75 | 5.6 | 2.74 | Excellent | Excellent |
| Example 14 | 3.3 | 96.5 | a | 0.039 | 1.60 | 245 | 85 | 1.06 | 21.25 | 5.5 | 2.54 | Excellent | Excellent |
| Example 15 | 3.3 | 96.5 | a | 0.039 | 1.60 | 243 | 82 | 1.03 | 20.50 | 5.6 | 2.52 | Excellent | Excellent |
| Example 16 | 5.2 | 90.1 | a | 0.032 | 1.40 | 239 | 47 | 0.82 | 3.36 | 6.0 | 0.74 | Excellent | Bad |
| Example 17 | 3.4 | 98.5 | a | 0.068 | 1.40 | 247 | 105 | 1.31 | 15.00 | 2.8 | 2.55 | Excellent | Excellent |
| Example 18 | 3.4 | 100.0 | a | 0.085 | 0.50 | 253 | 40 | 0.70 | 1.74 | 0.8 | 0.98 | Good | Bad |
| Example 19 | 3.4 | 100.0 | a | 0.083 | 0.50 | 254 | 40 | 0.70 | 2.22 | 0.8 | 1.23 | Excellent | Bad |
| Example 20 | 5.6 | 96.5 | a | 0.074 | 0.50 | 262 | 38 | 0.70 | 1.65 | 0.9 | 0.88 | Good | Bad |
| Example 21 | 4.7 | 80.5 | a | 0.035 | 0.70 | 259 | 45 | 0.83 | 3.75 | 2.5 | 1.33 | Excellent | Good |
| Example 22 | 4.8 | 82.0 | a | 0.041 | 0.70 | 250 | 43 | 0.80 | 2.87 | 2.3 | 1.08 | Excellent | Good |

**[Table 5]**

| | | | Metal foil composite | | | | | | | | | | |
|---|---|---|---|---|---|---|---|---|---|---|---|---|---|
| | E (Gpa) | E/Ea x100 | Structure | T (mm) | f1 (N/mm) | F (MPa) | L (%) | L/I₁ | L/I2 | 33f1 /(FxT) | (f3xt3) / (f2xt2) | Evalutation | |
| | | | | | | | | | | | | Bending properties | Press formability |
| Example 23 | 4.9 | 81.0 | a | 0.022 | 0.30 | 261 | 35 | 0.88 | 5.00 | 1.7 | 1.70 | Excellent | Good |
| Example 24 | 4.9 | 81.7 | a | 0.022 | 0.30 | 261 | 37 | 0.93 | 5.29 | 1.7 | 1.70 | Excellent | Good |
| Example 25 | 5.4 | 89.3 | a | 0.022 | 0.30 | 261 | 39 | 0.98 | 5.57 | 1.7 | 1.78 | Excellent | Good |
| Example 26 | 5.0 | 90.4 | b | 0.032 | 1.20 | 239 | 44 | 0.81 | 8.80 | 5.2 | 1.92 | Excellent | Good |
| Example 27 | 5.0 | 90.7 | b | 0.053 | 1.10 | 215 | 58 | 1.02 | 11.60 | 3.2 | 2.99 | Excellent | Excellent |
| Example 28 | 5.0 | 90.4 | b | 0.038 | 1.10 | 232 | 43 | 0.80 | 3.58 | 4.1 | 1.11 | Excellent | Good |
| Example 29 | 5.0 | 90.4 | b | 0.050 | 1.10 | 224 | 44 | 0.81 | 2.93 | 3.2 | 0.73 | Excellent | Bad |
| Example 30 | 5.0 | 90.7 | b | 0.065 | 1.10 | 199 | 60 | 1.05 | 10.00 | 2.8 | 2.31 | Excellent | Excellent |
| Example 31 | 5.0 | 90.4 | b | 0.050 | 0.70 | 171 | 43 | 0.80 | 8.60 | 2.7 | 1.11 | Excellent | Good |
| Example 32 | 5.0 | 90.4 | b | 0.038 | 0.70 | 186 | 43 | 0.80 | 8.60 | 3.3 | 1.44 | Excellent | Good |
| Example 33 | 5.0 | 90.4 | b | 0.050 | 0.70 | 171 | 43 | 0.80 | 6.14 | 2.7 | 0.93 | Excellent | Bad |
| Example 34 | 5.0 | 90.7 | b | 0.095 | 0.50 | 228 | 38 | 0.70 | 2.11 | 0.8 | 0.79 | Good | Bad |
| Example 35 | 5.7 | 89.8 | b | 0.038 | 0.70 | 232 | 35 | 0.81 | 2.92 | 2.6 | 1.11 | Excellent | Good |
| Example 36 | 5.7 | 90.5 | b | 0.115 | 0.50 | 234 | 32 | 0.74 | 1.19 | 0.6 | 0.88 | Good | Bad |
| Example 37 | 5.5 | 94.9 | c | 0.027 | 1.20 | 240 | 48 | 0.80 | 4.00 . | 6.1 | 2.21 | Excellent | Good |
| Example 38 | 5.2 | 90.1 | c | 0.014 | 1.20 | 214 | 105 | 1.75 | 21.00 | 13.2 | 1.44 | Excellent | Excellent |
| Example 39 | 5.2 | 90.5 | d | 0.053 | 0.60 | 215 | 62 | 1.03 | 12.40 | 1.7 | 2.99 | Excellent | Excellent |
| Example 40 | 5.2 | 90.5 | d | 0.053 | 0.60 | 215 | 49 | 0.82 | 4.08 | 1.7 | 2.30 | Excellent | Good |
| Comparative Example 1 | 4.1 | 70.0 | a | 0.035 | 0.70 | 259 | 7 | 0.13 | 0.58 | 2.5 | 1.33 | Bad | Bad |
| Comparative Example 2 | 4.4 | 75.9 | a | 0.030 | 1.30 | 254 | 15 | 0.30 | 0.80 | 2.5 | 1.33 | Bad | Bad |
| Comparative Example 3 | 4.1 | 70.0 | b | 0.047 | 0.70 | 244 | 7 | 0.13 | 0.58 | 2.0 | 1.33 | Bad | Bad |
| Comparative Example 4 | 4.4 | 75.6 | b | 0.042 | 1.30 | 238 | 8 | 0.15 | 0.67 | 4.3 | 1.33 | Bad | Bad |
| Comparative Example 5 | 4.4 | 75.4 | c | 0.040 | 0.70 | 263 | 18 | 0.33 | 1.50 | 2.2 | 1.75 | Bad | Bad |
| Comparative Example 6 | 4.4 | 75.6 | d | 0.042 | 1.30 | 238 | 16 | 0.30 | 1.33 | 4.3 | 1.73 | Bad | Bad |
| Comparative Example 7 | 4.4 | 73.4 | a | 0.023 | 0.30 | 259 | 9 | 0.23 | 0.7 | 1.7 | 1.43 | Bad | Bad |
| Comparative Example 8 | 3.3 | 54.6 | a | 0.030 | 0.30 | 266 | 6 | 0.15 | 0.50 | 1.2 | 1.61 | Bad | Bad |

**[Table 6]**

| | | | Metal foil composite | | | | | | | | | | |
|---|---|---|---|---|---|---|---|---|---|---|---|---|---|
| | E (Gpa) | E/Ea x100 | Structure | T (mm) | f1 (N/mm) | F (MPa) | L (%) | L/I₁ | L/I2 | 33f1 /(FxT) | (f3xt3)/ (f2xt2) | Evalutation | |
| | | | | | | | | | | | | Bending properties | Press formability |
| Example 41 | 5.2 | 82.5 | a | 0.063 | 1.10 | 220 | 38 | 0.88 | 2.71 | 2.6 | 2.31 | Excellent | Good |
| Example 42 | 5.2 | 82.5 | a | 0.063 | 0.98 | 200 | 37 | 0.86 | 4.11 | 2.6 | 2.98 | Excellent | Good |
| Example 43 | 5.2 | 82.5 | a | 0.063 | 1.20 | 194 | 48 | 1.12 | 6.86 | 3.2 | 3.47 | Excellent | Excellent |
| Example 44 | 5.2 | 82.5 | a | 0.063 | 1.25 | 195 | 50 | 1.16 | 7.14 | 3.4 | 3.58 | Excellent | Excellent |
| Example 45 | 5.2 | 82.5 | a | 0.063 | 1.22 | 196 | 45 | 1.05 | 5.00 | 3.3 | 3.33 | Excellent | Excellent |
| Example 46 | 5.2 | 82.5 | a | 0.063 | 1.32 | 220 | 41 | 0.95 | 3.42 | 3.1 | 2.96 | Excellent | Good |
| Example 47 | 5.2 | 82.5 | a | 0.063 | 1.25 | 198 | 47 | 1.09 | 3.92 | 3.3 | 3.33 | Excellent | Excellent |
| Example 48 | 5.2 | 82.5 | a | 0.063 | 1.27 | 201 | 41 | 0.95 | 2.93 | 3.3 | 3.24 | Excellent | Good |
| Example 49 | 5.2 | 82.5 | a | 0.063 | 1.21 | 215 | 40 | 0.93 | 2.67 | 2.9 | 3.04 | Excellent | Good |
| Example 50 | 5.2 | 82.5 | a | 0.063 | 1.35 | 211 | 38 | 0.88 | 2.38 | 3.4 | 2.96 | Excellent | Good |
| Example 51 | 5.0 | 86.2 | a | 0.053 | 0.60 | 255 | 38 | 0.63 | 2.11 | 1.5 | 1.72 | Excellent | Good |
| Example 52 | 4.9 | 81.7 | a | 0.033 | 0.20 | 253 | 33 | 0.93 | 5.29 | 0.8 | 0.68 | Good | Bad |
| Example 53 | 5.7 | 90.5 | a | 0.080 | 0.78 | 185 | 48 | 0.84 | 8.00 | 1.7 | 3.25 | Excellent | Good |
| Example 54 | 5.7 | 90.5 | a | 0.073 | 1.25 | 275 | 45 | 0.79 | 3.75 | 2.1 | 1.40 | Excellent | Good |
| Example 55 | 5.7 | 90.5 | a | 0.073 | 1.33 | 268 | 43 | 0.75 | 2.87 | 2.2 | 1.56 | Excellent | Good |
| Example 56 | 5.7 | 90.5 | a | 0.073 | 1.34 | 270 | 43 | 0.75 | 2.53 | 2.2 | 1.54 | Excellent | Good |
| Example 57 | 5.7 | 90.5 | a | 0.073 | 1.34 | 269 | 43 | 0.75 | 2.87 | 2.3 | 1.48 | Excellent | Good |
| Example 58 | 5.7 | 90.5 | a | 0.073 | 1.32 | 277 | 40 | 0.70 | 3.33 | 2.2 | 1.53 | Excellent | Good |
| Example 59 | 5.7 | 90.5 | a | 0.073 | 1.25 | 310 | 40 | 0.70 | 2.86 | 1.8 | 1.13 | Excellent | Good |
| Example 60 | 5.7 | 90.5 | a | 0.073 | 1.33 | 275 | 41 | 0.72 | 3.15 | 2.2 | 1.63 | Excellent | Good |
| Example 61 | 5.7 | 90.5 | a | 0.073 | 1.22 | 299 | 41 | 0.72 | 2.93 | 1.8 | 1.23 | Excellent | Good |
| Example 62 | 5.7 | 90.5 | a | 0.073 | 1.18 | 312 | 40 | 0.70 | 3.08 | 1.7 | 1.13 | Excellent | Good |
| Example 63 | 5.7 | 90.5 | a | 0.073 | 1.23 | 298 | 42 | 0.74 | 2.80 | 1.9 | 1.23 | Excellent | Good |
| Example 64 | 5.7 | 90.5 | a | 0.081 | 1.15 | 340 | 37 | 0.65 | 2.85 | 1.4 | 0.76 | Excellent | Bad |

As apparent from Tables 1 to 6, in each Examples where E/Ea is 80 to 100%, the bending properties are excellent.

In Examples 1 to 3, 6, 8 to 15, 17, 27, 30, 38, 39 and 43 to 45, 47 where 1 <= 33f₁/(F x T), (f₃ x t₃)/(f₂ x t₂) => 1, L => l₁ and L > l₂ are all satisfied, both the bending properties and the press formability are best (Excellent).

In Examples 4, 5, 7, 21 to 26, 28, 31, 32, 35, 37, 40, 51, 41, 42, 46, 48 to 50 and 53 to 63 where L < l₁, the bending properties are best (Excellent), but the press formability are a bit excellent(Good).

In Example 19 where L < l₁ and 1 > 33f₁/(F x T), the bending properties are best (Excellent), but the press formability are poor (Bad).

In Examples 16, 29, 33 and 64 where L < l₁ and (f₃ x t₃)/(f₂ x t₂) < 1, the bending properties are best (Excellent), but the press formability are poor (Bad).

In Examples 18, 20, 34, 36 and 52 where L < l₁, 1 > 33f₁/(F x T) and (f₃ x t₃)/(f₂ x t₂) < 1, the bending properties are a bit excellent (Good) and the press formability are poor (Bad).

In contrast, in each Comparative Example where E/Ea is less than 80%, the bending properties are poor.

### [Reference Numerals]

- 2: Metal foil
- 2a: Circuit of copper foil
- 4: Adhesion layer
- 6: Resin layer
- 8: Protective resin layer

## Claims

1. A metal foil composite comprising a resin layer and a metal foil laminated on one or both surfaces of the resin layer via a adhesion layer, wherein elastic modulus of a total layer including the adhesion layer and the resin layer is 80% to 100% of the elastic modulus of the resin layer.

2. The metal foil composite according to Claim 1, wherein 1 <= 33f₁/(F x T) is satisfied when f₁ (N/mm) is 180° peeling strength between the metal foil and the resin layer, F(MPa) is strength of the metal foil composite under tensile strain of 30%, and T (mm) is a thickness of the metal foil composite.

3. The metal foil composite according to Claim 1 or 2, wherein (f₃ x t₃)/(f₂ x t₂) => 1 is satisfied, when t₂ (mm) is a thickness of the metal foil, f₂ (MPa) is a stress of the copper foil under tensile strain of 4%, t₃ (mm) is a total thickness of the total layer, and f₃ (MPa) is a stress of the total layer under tensile strain of 4%.

4. The metal foil composite according to any one of Claims 1 to 3, wherein fracture strain L of the metal foil composite, fracture strain l₁ of the resin layer alone and fracture strain l₂ of the metal foil satisfy L => l₁ and L > l₂.

5. A flexible printed circuit, using the metal foil composite according to any one of Claims 1 to 4, wherein the metal foil is a copper foil.

6. A formed product, provided by working the metal foil composite according to any one of Claims 1 to 4.

7. A method of producing a formed product, comprising working the metal foil composite according to any one of Claims 1 to 4.

## Patentansprüche

1. Metallfolienverbundstoff, umfassend eine Harzschicht und eine mittels einer Adhäsionsschicht auf eine oder beide Oberflächen der Harzschicht laminierte Metallfolie, wobei der Elastizitätsmodul einer Gesamtschicht einschließlich der Adhäsionsschicht und der Harzschicht 80% bis 100% des Elastizitätsmoduls der Harzschicht beträgt.

2. Metallfolienverbundstoff gemäß Anspruch 1, wobei 1 <= 33f_{1/}(F x T) erfüllt ist, wenn f₁ (N/mm) die 180°-Abschälfestigkeit zwischen der Metallfolie und der Harzschicht ist, F (MPa) die Festigkeit des Metallfolienverbundstoffs unter Zugdehnung von 30% ist und T (mm) eine Dicke des Metallfolienverbundstoffs ist.

3. Metallfolienverbundstoff gemäß Anspruch 1 oder 2, wobei (f₃ x t₃)/(f₂ x t₂) => 1 erfüllt ist, wenn t₂ (mm) eine Dicke der Metallfolie ist, f₂ (MPa) eine Spannung der Kupferfolie unter Zugdehnung von 4% ist, t₃ (mm) eine Gesamtdicke der Gesamtschicht ist und f₃ (MPa) eine Spannung der Gesamtschicht unter Zugdehnung von 4% ist.

4. Metallfolienverbundstoff gemäß irgendeinem der Ansprüche 1 bis 3, wobei die Bruchdehnung L des Metallfolienverbundstoffs, die Bruchdehnung l₁ der Harzschicht an sich und die Bruchdehnung l₂ der Metallfolie L => l₁ und L > l₂ erfüllen.

5. Flexible Leiterplatte unter Verwendung des Metallfolienverbundstoffs gemäß irgendeinem der Ansprüche 1 bis 4, wobei die Metallfolie eine Kupferfolie ist.

6. Gebildetes Erzeugnis, bereitgestellt durch Verarbeitung des Metallfolienverbundstoffs gemäß irgendeinem der Ansprüche 1 bis 4.

7. Verfahren zur Herstellung eines gebildeten Erzeugnisses, umfassend die Verarbeitung des Metallfolienverbundstoffs gemäß irgendeinem der Ansprüche 1 bis 4.

## Revendications

1. Composite de feuille métallique comprenant une couche de résine et une feuille métallique stratifiée sur une surface, ou les deux, de la couche de résine par le biais d'une couche adhésive, dans lequel le module élastique d'une couche totale incluant la couche adhésive et la couche de résine est de 80 % à 100 % du module élastique de la couche de résine.

2. Composite de feuille métallique selon la revendication 1, dans lequel l'inégalité 1 ≤ 33f₁/(F x T) est satisfaite quand f₁ (N/mm) est la résistance à l'arrachage à 180° entre la feuille métallique et la couche de résine, F(MPa) est la résistance du composite de feuille métallique à un allongement en traction de 30 %, et T (mm) est une épaisseur du composite de feuille métallique.

3. Composite de feuille métallique selon la revendication 1 ou 2, dans lequel l'inégalité (f₃ x t₃)/(f₂ x t₂) ≥ 1 est satisfaite, quand t₂ (mm) est une épaisseur de la feuille métallique, f₂ (MPa) est une résistance de la feuille en cuivre à un allongement en traction de 4 %, t₃ (mm) est une épaisseur totale de la totalité de la couche, et f₃ (MPa) est une résistance de la totalité de la couche à un allongement en traction de 4 %.

4. Composite de feuille métallique selon l'une quelconque des revendications 1 à 3, dans lequel l'allongement à la rupture L du composite de feuille métallique, l'allongement à la rupture l₁ de la couche de résine seule et l'allongement à la rupture l₂ de la feuille métallique satisfont aux inégalités L ≥ l₁ et L > l₂.

5. Carte de circuit imprimé flexible utilisant le composite de feuille métallique selon l'une quelconque des revendications 1 à 4, dans lequel la feuille métallique est une feuille de cuivre.

6. Produit moulé, fourni par le travail du composite de la feuille métallique selon l'une quelconque des revendications 1 à 4.

7. Procédé de production d'un produit moulé, comprenant le travail du composite de feuille métallique selon l'une quelconque des revendications 1 à 4.
